# EUROPEAN PATENT APPLICATION

(11) **EP 3 468 332 A1**
(43) Date of publication of application: **10.04.2019**
(21) Application number: 17806521.5
(22) Date of filing: 25.05.2017
(51) Int. Cl.: H05K 13/04, B25J 15/08

(54) **ELECTRONIC COMPONENT INSERTING DEVICE**

(30) Priority: 31.05.2016 JP 2016108905
(71) Applicant: Kawasaki Jukogyo Kabushiki Kaisha, Kobe-shi, Hyogo 650-8670 (JP)
(72) Inventor: HASHIMOTO, Yasuhiko, Chuo-ku, Kobe-shi Hyogo 650-8670 (JP); HASEGAWA, Shogo, Chuo-ku, Kobe-shi Hyogo 650-8670 (JP); BANDO, Kenji, Chuo-ku, Kobe-shi Hyogo 650-8670 (JP); TANAKA, Keiichi, Chuo-ku, Kobe-shi Hyogo 650-8670 (JP); TAMADA, Soichi, Chuo-ku, Kobe-shi Hyogo 650-8670 (JP); IWASAKI, Yukio, Chuo-ku, Kobe-shi Hyogo 650-8670 (JP); KATAFUCHI, Hiroshi, Chuo-ku, Kobe-shi Hyogo 650-8670 (JP); WAKIYAMA, Kenji, Chuo-ku, Kobe-shi Hyogo 650-8670 (JP); UCHIDA, Takuma, Chuo-ku, Kobe-shi Hyogo 650-8670 (JP); HIRATA, Kazunori, Chuo-ku, Kobe-shi Hyogo 650-8670 (JP)
(74) Representative: Witte, Weller & Partner Patentanwälte mbB
(86) International application number: PCT/JP2017/019546
(87) International publication number: WO 2017/208964

(57) **Abstract**

An electronic-component inserting device includes a component gripper configured to hold a main body of an electronic component, an operating member provided to the component gripper, a lead gripper configured to grip the leads of the electronic component held by the component gripper, and a moving device configured to move the component gripper in a first direction relatively to the lead gripper. The lead gripper has a pair of fingers configured to pinch the leads from both sides in second directions perpendicular to the first direction, and a biasing member configured to bias the pair of fingers so that fingertips of the fingers are opened. The fingers are provided with acted parts on which an acting force from the operating member acts so that the fingertips of the fingers are closed.

## Description

### TECHNICAL FIELD

The present disclosure relates to an inserting device which inserts leads of an electronic component with the leads into a substrate.

### BACKGROUND ART

There is a so-called "lead component" in which leads are connected to electrodes of a main body of an electronic component, among electronic components. Such an electronic component is fixed to an electronic substrate by inserting its leads into the through-holes formed in the electronic substrate and soldering the connections from the back side of the electronic substrate. Conventionally, the electronic-component inserting devices have been known which automatically attach electronic components to an electronic substrate by inserting leads into through-holes of the electronic substrate. Patent Document 1 discloses this kind of technology.

The electronic-component attaching device (electronic-component inserting device) disclosed in Patent Document 1 cuts leads of an electronic component, and automatically attaches the electronic component to an electronic substrate. This electronic-component attaching device includes a gripper having a pair of arms, a pressing member which relatively displaces vertically with respect to the pair of arms, and a moving mechanism which relatively moves the gripper and the electronic substrate. The pair of arms have a pair of support parts which sandwich the main body of the electronic component at base-end parts, and a pair of blade parts which sandwich the leads at tip-end parts. The electronic-component attaching device first holds the main body of the electronic component by the pair of support parts by closing the pair of arms, and cuts and holds the leads by the pair of blade parts. Then, the device presses the electronic component toward the electronic substrate by the pressing member while opening the pair of arms to attach the electronic component to the electronic substrate.

### [Reference Document of Conventional Art]

### [Patent Document]

[Patent Document 1] JP1994-034300U

### DESCRIPTION OF THE DISCLOSURE

### [Problems to be Solved by the Disclosure]

In the device of Patent Document 1, each of the gripper, the pressing member, and the moving mechanism is provided with an actuator for exclusive use, and the plurality of actuators are controlled so that they synchronizedly operate.

### [Summary of the Disclosure]

Meanwhile, the present inventors have examined constructing an electronic-component inserting device using a dual-arm robot. That is, an end effector is attached to a hand part of each arm of the dual-arm robot, and the dual-arm robot is operated to function as an electronic-component inserting device. In such an electronic-component inserting device, a component holding function to hold the electronic component and insert the electronic component into the substrate, and a lead guiding function to guide the leads of the electronic component are possible to be distributed to respective arms. However, if distributing the component holding function and the lead guiding function to the respective arms, which are functions to cooperate with each other, operations may not be performed normally when a time lag occurs between the functional parts.

According to one aspect of the present disclosure, an electronic-component inserting device is provided, which inserts an electronic component with leads into through-holes of a substrate. The device includes a component gripper configured to hold a main body of the electronic component, an operating member provided to the component gripper, a lead gripper configured to grip the leads of the electronic component held by the component gripper, and a moving device configured to move the component gripper in a first direction relatively to the lead gripper. The lead gripper has a pair of fingers configured to pinch the leads from both sides in second directions perpendicular to the first direction, and a biasing member configured to bias the pair of fingers so that fingertips of the fingers are opened. The fingers are provided with acted parts on which an acting force from the operating member acts so that the fingertips of the fingers are closed.

In the electronic-component inserting device, when the operating member moves in the first direction in association with the component gripper, the lead gripper receives the acting force from the operating member to close the fingertips of the pair of fingers. That is, an actuator for exclusive use for opening and closing the lead gripper is not provided, but the lead gripper is mechanically opened and closed by the operating member which integrally moves with the component gripper. Therefore, the timings of the movement of the component gripper and the opening and closing of the lead gripper are synchronized with each other, and their cooperation is promised. Moreover, since the actuator for exclusive use for opening and closing the lead gripper is not provided, a controller for this actuator is unnecessary. Moreover, the electronic-component inserting device utilizing a dual-arm robot, in which the component gripper and the lead gripper are distributed to arms, respectively, is easily implemented.

### [Effect of the Disclosure]

According to the present disclosure, in the electronic-component inserting device provided with the component gripper which holds the electronic component and inserts it into the substrate, and the lead gripper which guides the leads of the electronic component, the timings of the movement of the component gripper and opening and closing of the lead gripper is synchronized without controlling the opening and closing of the lead gripper.

### BRIEF DESCRIPTION OF DRAWINGS

Fig. 1 is a front elevation schematically illustrating a structure of an electronic-component inserting device according to one embodiment of the present disclosure.
Fig. 2 is a view illustrating one example of the electronic-component inserting device in which both of an attaching head moving mechanism and a guiding head moving mechanism are robot arms.
Fig. 3 is a side elevation of the attaching head viewed from the guiding head side.
Fig. 4 is a side elevation of the guiding head viewed from the attaching head side.
Fig. 5 is an enlarged side elevation of grip parts of fingers.
Fig. 6 is an enlarged plan view of the grip parts of the fingers.
Fig. 7 is a view illustrating a configuration of a control system of the electronic-component inserting device.
Fig. 8 is a side elevation of the guiding head viewed from the attaching head side when an operating member is in an open position.
Fig. 9 is a front elevation of the electronic-component inserting device when the operating member is in the open position.
Fig. 10 is a side elevation of the guiding head viewed from the attaching head side when the operating member is in a closed position.
Fig. 11 is a front elevation schematically illustrating a structure of an electronic-component inserting device according to Modification 1.
Fig. 12 is a front elevation schematically illustrating a structure of an electronic-component inserting device according to Modification 2.

### MODES FOR CARRYING OUT THE DISCLOSURE

Next, one embodiment of the present disclosure is described with reference to the drawings. An electronic-component inserting device according to this embodiment of the present disclosure is a device to automatically attach an electronic component with leads to an electronic substrate. Particularly, the electronic-component inserting device performs a work in which it takes out the electronic component from a component feeding device and holds the electronic component, conveys the electronic component to a given position on the electronic substrate, adjusts the leads of the electronic component, and inserts the leads into given through-holes formed in the electronic substrate.

### [Outline of Structure of Electronic-component Inserting Device 1]

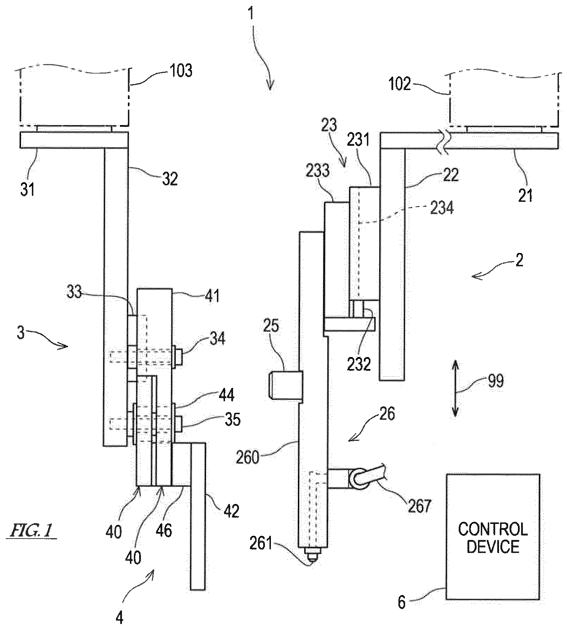

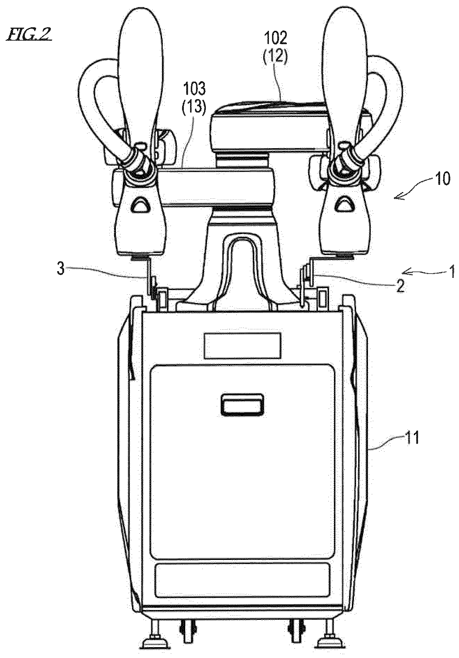

Fig. 1 is a front elevation schematically illustrating the structure of the electronic-component inserting device 1 according to this embodiment of the present disclosure, and Fig. 2 is a view illustrating one example of the electronic-component inserting device 1 in which both of an attaching head moving mechanism 102 and a guiding head moving mechanism 103 are arms 12 and 13, respectively. As illustrated in Fig. 1, the electronic-component inserting device 1 includes an attaching head 2, a guiding head 3, the attaching head moving mechanism 102, the guiding head moving mechanism 103, and a control device 6 that governs operations of these elements.

The attaching head 2 holds an electronic component 9 to be attached to the electronic substrate, and inserts leads 92 of the currently-holding electronic component 9 into the given through-holes of the electronic substrate. The attaching head moving mechanism 102 is a mechanism which moves the attaching head 2 relatively to the electronic substrate so that the electronic component 9 moves to the given attaching position on the electronic substrate.

Moreover, the guiding head 3 adjusts the leads 92 of the electronic component 9 held by the attaching head 2, and guides the leads 92 to the through-holes. The guiding head moving mechanism 103 is a mechanism which moves the guiding head 3 relatively to the attaching head 2 (or the electronic substrate).

As illustrated in Fig. 2, the electronic-component inserting device 1 according to this embodiment is constructed using a dual-arm robot 10. The dual-arm robot 10 has a pedestal 11 and a pair of robot arms 12 and 13 supported by the pedestal 11. The attaching head 2 is attached to a hand part of one arm 12 among the pair of arms 12 and 13, while the guiding head 3 is attached to a hand part of the other arm 13. That is, in this embodiment, one arm 12 of the dual-arm robot 10 functions as the attaching head moving mechanism 102, and the other arm 13 functions as the guiding head moving mechanism 103. The arms 12 and 13 may adopt a common horizontal articulated robot arm, and since the structure thereof is known, detailed description of the arms 12 and 13 is omitted. Below, the attaching head 2, the guiding head 3, and the control device 6 will be particularly described in detail among the elements of the electronic-component inserting device 1.

### [Structure of Attaching Head 2]

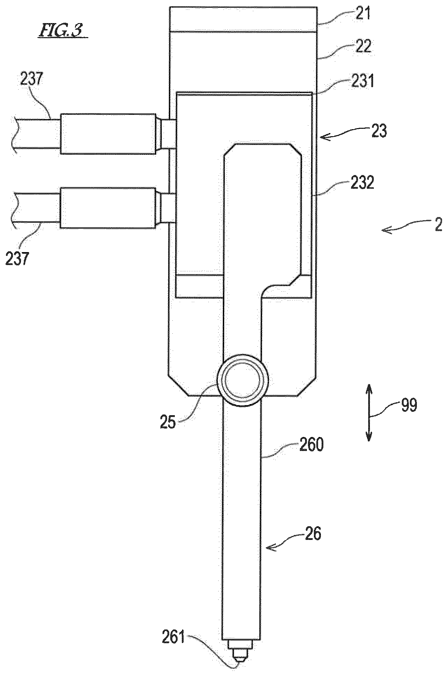

Fig. 3 is a side elevation of the attaching head 2 viewed from the guiding head 3 side. As illustrated in Figs. 1 and 3, the attaching head 2 according to this embodiment is a so-called nozzle head. This attaching head 2 includes a base 22, a component gripper 26, a moving device 23 which moves the component gripper 26 with respect to the base 22 in a first direction(s) 99, and an operating member 25 provided to the component gripper 26. Here, "the first direction 99" is a direction parallel to opening axes of the through-holes of the electronic substrate, i.e., a direction perpendicular to a surface of the electronic substrate on which the electronic component 9 is attached, and is generally a vertical or up-and-down direction.

The base 22 is a plate member having a main surface parallel to the first directions 99. An interface plate 21 is coupled to the base 22. This interface plate 21 is connected with an interface on the attaching head moving mechanism 102 side. Note that, the interface plate 21 may be omitted depending on the form of the attaching head moving mechanism 102, and the base 22 may be directly connected to the attaching head moving mechanism 102.

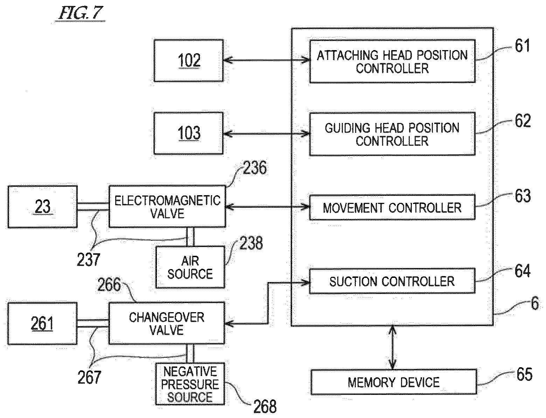

The moving device 23 is a so-called linear motion device. The moving device 23 includes an air cylinder 231 fixed to the base 22, a rod 232 which extends and contracts from/to the air cylinder 231 in the first directions 99, and a slider 233 coupled to the rod 232. A rail 234 extending in the first directions 99 is formed in a casing of the air cylinder 231 to guide the slider 233. The air cylinder 231 is connected with an air source 238 via piping 237, and compressed air is supplied from the air source 238 (see Fig. 7). An electromagnetic valve 236 which switches the compressed air to the air cylinder 231 between "supplying" and "discharging" is formed in the piping 237. The rod 232 extends and contracts by the supplying and discharging of the compressed air to the air cylinder 231. The slider 233 coupled to the rod 232 slides on the rail 234 in association with the expansion and contraction of the rod 232 to move in the first directions 99.

The component gripper 26 includes an arm 260 extending in the first directions 99, and a suction nozzle 261 provided to a tip-end part of the arm 260. The suction nozzle 261 is connected to a negative pressure source 268 via the piping 267 (see Fig. 7). The piping 267 is provided with a changeover valve 266 which switches between communication/block of the suction nozzle 261 and the negative pressure source 268. When the suction nozzle 261 communicates with the negative pressure source 268, a suction force is generated at the suction nozzle 261 by negative pressure.

A base-end part of the arm 260 is coupled to the slider 233 of the moving device 23. Thus, the component gripper 26 moves with respect to the base 22 in the first directions 99, according to the movement of the slider 233 of the moving device 23.

The operating member 25 is fixed to the component gripper 26 so that it moves integrally with the component gripper 26. The operating member 25 according to this embodiment is provided to the arm 260 of the component gripper 26, and projects from the component gripper 26 in a direction perpendicular to the first directions 99. The operating member 25 is an element which acts on a lead gripper 4 (described later) to open and close the lead gripper 4.

### [Structure of Guiding Head 3]

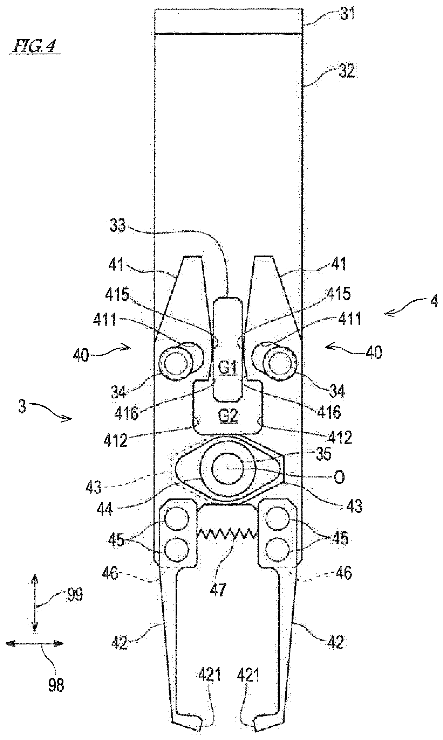

Fig. 4 is a side elevation of the guiding head 3 viewed from the attaching head 2 side. As illustrated in Figs. 1 and 4, the guiding head 3 includes a base 32 and the lead gripper 4 supported by the base 32.

The base 32 is a plate member having a main surface parallel to the first directions 99. An interface plate 31 is coupled to the base 32. This interface plate 31 is connected with an interface on the guiding head moving mechanism 103 side. Note that the interface plate 31 may be omitted depending on the form of the guiding head moving mechanism 103, and the base 32 may be directly connected to the guiding head moving mechanism 103.

The lead gripper 4 includes a pair of fingers 40 pivotably supported by the base 32, and a biasing member 47 which biases the pair of fingers 40 to open fingertips 421 of the pair of fingers 40 (i.e., separate the fingertips 421). The lead gripper 4 is a gripper which opens and closes by pivoting, and the pair of fingers 40 are structured so as to pinch the leads 92 of the electronic component 9 from both sides in second directions 98 perpendicular to the first directions 99. Note that, herein, for convenience of description, the second directions 98 are expressed as left-and-right directions, where the left side on the drawing paper of Fig. 4 may be expressed as the left, while the right side may similarly be expressed as the right.

Each finger 40 has an operating part 41 provided to a base-end part, a grip part 42 provided to a tip-end part, and a support part 43 provided to an intermediate part between the base-end part and the tip-end part. Tip ends of the fingers 40 are fingertips 421, and a state where the fingertips 421 of the pair of fingers 40 are separated from each other is referred to as a state where the lead gripper 4 is "opened," while a state where the fingertips 421 of the pair of fingers 40 are abutted on or sufficiently close to each other is referred to as a state where the lead gripper 4 is "closed."

The pair of fingers 40 are pivotably supported by a pivot 35 fixed to the base 32 between the operating part 41 and the grip part 42 (i.e., the support part 43) so that the grip parts 42 are opposed to each other in the second directions 98 and the operating parts 41 are opposed to each other in the second directions 98. The pair of fingers 40 are constructed to be substantially symmetrical with respect to a straight line parallel to the first directions 99, which passes through the pivot 35. Thus, below, corresponding elements of the pair of fingers 40 are denoted with the same reference numerals in the figures to omit redundant description.

The support part 43 of the finger 40 protrudes toward the other finger, rather than other parts of the finger 40. In other words, the support part 43 of the right finger 40 protrudes to the left, rather than other parts of this finger 40, while the support part 43 of the left finger 40 protrudes to the right, rather than other parts of this finger 40. The support part 43 is coupled to an outer ring of a bearing unit 44, and the pivot 35 is inserted into an inner ring of the bearing unit 44. Thus, the fingers 40 are pivotable about the pivot 35 as a pivot center O.

The operating part 41 of the finger 40 is provided with functional parts, such as a contact part 415, an acted part 416, and an escape part 412, in this order from the base-end side of a part opposed to the other finger 40.

The contact parts 415 of the pair of fingers 40 are opposed to each other and are separated therebetween. The contact parts 415 may contact a rotation regulating block 33. The rotation regulating block 33 is located between the contact parts 415 of the pair of fingers 40 in the second directions 98 and located on an extended line of the pivot 35 in the first directions 99, and is fixed to the base 32. The rotation of the finger 40 in an opening direction is regulated by the contact part 415 contacting the rotation regulating block 33. The term "opening direction" as used herein refers to a rotating direction of the finger 40 when opening the lead gripper 4, while the opposite rotating direction of the finger 40 from the opening direction is referred to as "closing direction."

The acted parts 416 of the pair of fingers 40 oppose to each other and are separated therebetween, thereby forming a first gap G1 between the acted parts 416. A width of the first gap G 1 is smaller than a width of the operating member 25 in the second directions 98. Therefore, the operating member 25 located in the first gap G1 (i.e., between the acted parts 416) acts on the acted part 416.

The escape parts 412 of the pair of fingers 40 oppose to each other and are separated therebetween, thereby forming a second gap G2 between the escape parts 412. A width of the second gap G2 is larger than the width of the operating member 25 in the second directions 98 which is inserted therein. In other words, the escape parts 412 is located away from the operating member 25 so that the operating member 25 located in the second gap G2 (i.e., between the escape parts 412) does not act on the escape parts 412. As a result, the operating member 25 in the second gap G2 is avoided from interfering with the operating parts 41 (particularly, the escape parts 412).

The first gap G1 and the second gap G2 are aligned in the first directions 99. The second gap G2 is located on the electronic substrate side with respect to the first gap G1. In a state where the operating member 25 does not act on the fingers 40 and the lead gripper 4 is opened, the first gap G1 has a tapered shape which narrows from the second gap G2 by the pair of acted parts 416. Thus, the operating member 25 which moves from the second gap G2 to the first gap G1 slides on the acted parts 416, and reaches the first gap G1 while pushing open the operating parts 41 of the pair of fingers 40 to both left and right sides, i.e., closing the lead gripper 4.

Further, a rotation regulating hole 411 is formed in the operating part 41 of the finger 40. The rotation regulating hole 411 is an elongated hole extending in circumferential directions centering on the pivot center O. A rotation regulating pin 34 fixed to the base 32 is inserted into the rotation regulating hole 411. Rotation ranges of the fingers 40 are regulated by the rotation regulating holes 411 and the rotation regulating pins 34. Note that the rotation ranges of the fingers 40 may extend from a position where the fingertips 421 of the pair of fingers 40 contact each other to a position where the contact parts 415 contact the rotation regulating block 33.

The grip part 42 provided below the pivot center O of the finger 40 is formed by a separate member detachably attached through a spacer 46 to a member forming the operating part 41 and the support part 43. These members may be coupled by fasteners 45, for example. Thus, since the grip part 42 is formed by the separate member, the grip part 42 may be replaced according to the number and shape of the leads 92 of the electronic component 9. Note that the spacer 46 is to adjust the position of each grip part 42 so that the fingertips 421 of the pair of fingers 40 are abutted on each other.

Between the opened grip parts 42 of the finger 40 are sufficiently separated from each other in the second directions 98 to an extent that the component gripper 26 of the attaching head 2 can be inserted therebetween. A tip-end portion of each grip part 42 is bent toward the other grip part 42 so that the pair of fingertips 421 oppose to each other in the second directions 98.

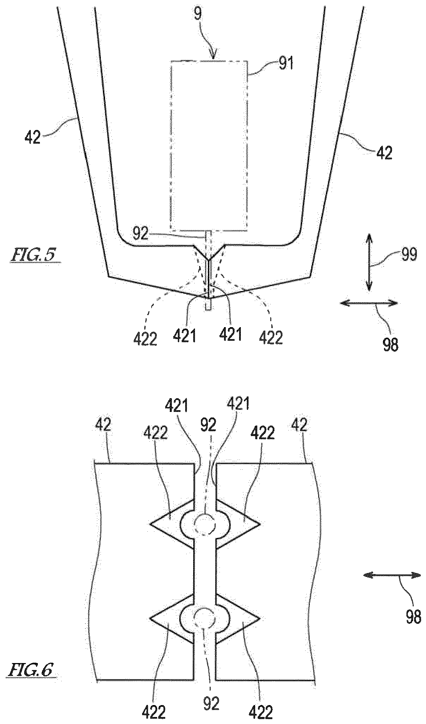

Fig. 5 is an enlarged side elevation of the grip parts 42 of the fingers 40, and Fig. 6 is an enlarged plan view of the grip parts 42 of the fingers 40. As illustrated in Figs. 5 and 6, the fingertips 421 provided to the pair of grip parts 42 abuts on or approaches to each other when the lead gripper 4 is closed. Corresponding number of guide grooves 422 to the number of the leads 92 of the electronic component 9 are formed in the fingertip 421. When the fingertips 421 abut on each other, the opposing guide grooves 422 are put together to form guide holes into which the leads 92 of the electronic component 9 are inserted. Each guide hole has a portion which extends in the first directions 99 and is gradually reduced in the cross-sectional area toward the electronic substrate. The cross-sectional shape of a portion of the guide hole close to the electronic substrate is formed in a circular shape having a slightly larger inner diameter than an outer diameter of the leads 92 of the electronic component 9.

### [Control Device 6]

Fig. 7 is a view illustrating a configuration of a control system of the electronic-component inserting device 1. As illustrated in Fig. 7, the control device 6 is connected communicatably wiredly or wirelessly with the attaching head moving mechanism 102, the guiding head moving mechanism 103, the electromagnetic valve 236, the changeover valve 266, and a memory device 65.

The control device 6 is a so-called a computer, and has an arithmetic processor, such as a CPU, and a memory, such as a ROM and a RAM (none of them is illustrated). The memory stores a control program executed by the control device 6, various fixed data, etc. The arithmetic processor transmits and receives data to/from external devices, such as an input device, an output device, and the memory device 65, which are not illustrated. Moreover, the arithmetic processor accepts inputs of detection signals from various sensors and outputs a control signal to each controlled object. In the control device 6, the arithmetic processor reads and performs software, such as the programs stored in the memory and/or the memory device 65, to perform processing for controlling various operations of the electronic-component inserting device 1. Note that the control device 6 may perform each processing by an integrated control with a single computer, or may perform each processing by a distributed control with a collaboration of a plurality of computers. Moreover, the control device 6 may be comprised of a microcontroller, a programmable logic controller (PLC), etc.

The control device 6 includes, as functional blocks, an attaching head position controller 61, a guiding head position controller 62, a movement controller 63, and a suction controller 64. In Fig. 7, although these functional blocks are collectively illustrated as a single control device 6, the functional blocks may be implemented by one or more computers where each functional block or combination(s) of the plurality of functional blocks is independent.

The attaching head position controller 61 controls operation of the attaching head moving mechanism 102 to move the attaching head 2 along a given path based on the program prestored in the memory device 65.

The guiding head position controller 62 controls operation of the guiding head moving mechanism 103 to move the guiding head 3 along a given path based on the program prestored in the memory device 65.

The movement controller 63 controls operation of the electromagnetic valve 236 based on the program prestored in the memory device 65 so that the component gripper 26 of the attaching head 2 moves vertically.

The suction controller 64 controls operation of the changeover valve 266 based on the program prestored in the memory device 65 to cause the suction nozzle 261 of the attaching head 2 to generate the suction force.

### [Method of Operating Electronic-component Inserting Device 1]

Next, the method of operating the electronic-component inserting device 1 having the structure described above is described.

First, the control device 6 operates the attaching head 2 and the attaching head moving mechanism 102 to take out or extract the electronic component 9 from the component feeding device (not illustrated) and hold it. Here, the attaching head moving mechanism 102 moves the attaching head 2 to an extraction position of the component feeding device. When the attaching head 2 reaches the extraction position, it causes the suction nozzle 261 to generate the suction force, and suck and hold the electronic component 9 by the suction nozzle 261.

Next, the control device 6 operates the guiding head moving mechanism 103 to move the lead gripper 4 to a given attaching position of the electronic substrate. Here, although the guiding head moving mechanism 103 moves the lead gripper 4 to the given attaching position, the electronic substrate may be moved. That is, the attaching head 2 and the electronic substrate move relatively to each other. This positioning of the lead gripper 4 may be performed simultaneously with the extracting and holding operation of the electronic component 9 of the attaching head 2.

The lead gripper 4 which moved to the given attaching position is open. Note that, in the lead gripper 4 positioned at the given attaching position, when the lead gripper 4 is closed, the guide holes between the fingertips 421 are located near openings of the through-holes of the electronic substrate and on the opening axes, respectively.

Next, the control device 6 operates the attaching head moving mechanism 102 to insert the operating member 25 of the attaching head 2 into the second gap G2 of the lead gripper 4. Here, the attaching head moving mechanism 102 may change the position and posture of the attaching head 2 so that the base 32 of the guiding head 3 and the base 32 of the attaching head 2 oppose to each other, position the attaching head 2 so that the second gap G2 of the lead gripper 4 and the operating member 25 of the attaching head 2 are located on the same straight line, and bring the attaching head 2 close to the lead gripper 4 to insert the operating member 25 into the second gap G2. Note that, in this embodiment, although the attaching head 2 moves, the guiding head 3 may move. That is, the attaching head 2 and the guiding head 3 may move relatively to each other, and the electronic component 9 may be located at a given attaching position in a state where the operating member 25 is inserted into the second gap G2.

In this embodiment, the second gap G2 of the lead gripper 4 is formed in a concaved part into which the operating member 25 is inserted. This concaved part may be used as a positioning hole of the component gripper 26 with respect to the lead gripper 4. As described above, when inserting the operating member 25 of the attaching head 2 into the second gap G2 of the lead gripper 4, a wrist of the arm 12 which is the attaching head moving mechanism 102 for moving the component gripper 26 is made flexibly displaceable by a compliance function, while a wrist of the arm 13 which is the guiding head moving mechanism 103 for moving the lead gripper 4 is fixed. In this state, when the operating member 25 of the attaching head 2 is inserted into the second gap G2 of the lead gripper 4, the component gripper 26 is positioned with respect to the lead gripper 4.

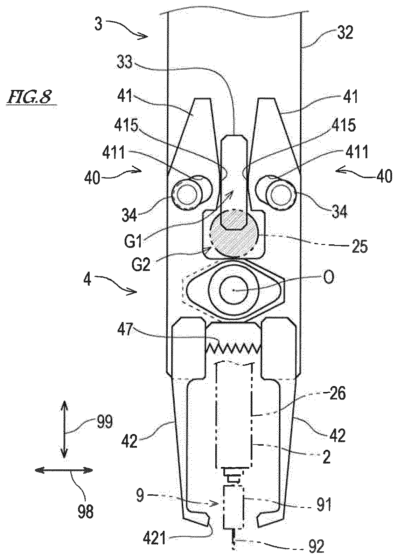

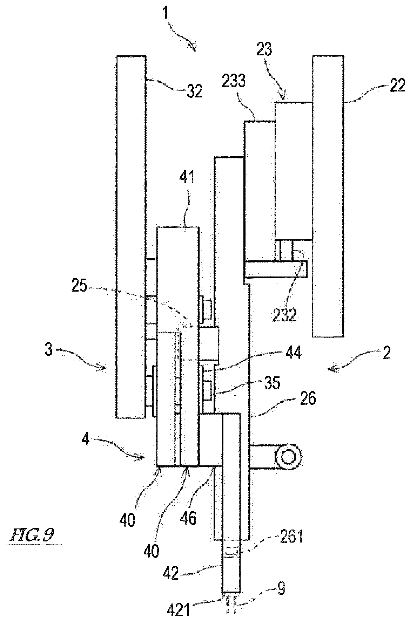

Fig. 8 is a side elevation of the guiding head 3 viewed from the attaching head 2 side when the operating member 25 is located in the second gap G2, and Fig. 9 is a front elevation of the electronic-component inserting device 1 when the operating member 25 is located in the second gap G2. In Fig. 8, the operating member 25 is virtually illustrated by a hatched two-dot chain line circle, and the component gripper 26 and the electronic component 9 sucked and held by the component gripper 26 are virtually illustrated by a two-dot chain line.

As illustrated in Figs. 8 and 9, when the operating member 25 is fitted in the second gap G2, the operating member 25 does not act on the finger 40, but the lead gripper 4 is opened by a biasing force of the biasing member 47. Moreover, when the operating member 25 is fitted in the second gap G2, the component gripper 26 holding the electronic component 9 is located between the pair of grip parts 42, and the leads 92 of the electronic component 9 are located substantially on the opening axes of the through-holes of the electronic substrate, respectively.

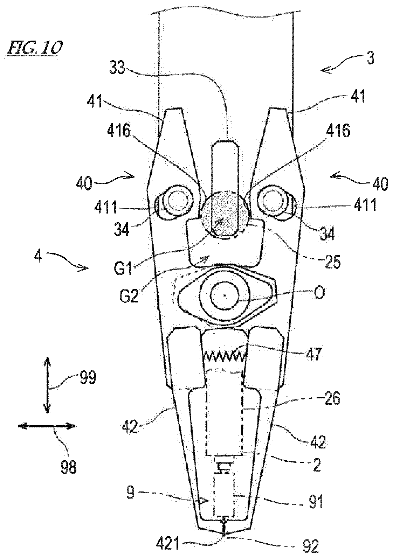

Fig. 10 is a side elevation of the guiding head 3 viewed from the attaching head 2 side when the operating member 25 is located in the first gap G1. In Fig. 10, the operating member 25 is virtually illustrated by a hatched two-dot-chain line circle, and the component gripper 26 and the electronic component 9 sucked and held by the component gripper 26 are virtually illustrated by a two-dot chain line. As illustrated in Fig. 10, the operating member 25 located in the first gap G1 acts on the acted parts 416 in the operating parts 41 of the lead gripper 4. Here, the operating member 25 may act on the contact parts 415. That is, the acted parts in the operating parts 41 of the lead gripper 4, on which the operating member 25 acts may be the acted parts 416, or the acted parts 416 and the contact parts 415.

The control device 6 operates the attaching head 2 so that the operating member 25 moves from the second gap G2 to the first gap G1 with respect to the lead gripper 4. Here, in the attaching head 2, the component gripper 26 moves by the operation of the moving device 23, and in association with this movement, the operating member 25 moves with respect to the lead gripper 4. Note that the guiding head moving mechanism 103 may move the operating member 25 and the component gripper 26 relatively to the lead gripper 4, instead of the moving device 23.

In the process where the operating member 25 moves from the second gap G2 to the first gap G1, the operating member 25 contacts the pair of acted parts 416 of the lead gripper 4 to extend a space between the pair of acted parts 416. Thus, the fingers 40 of the lead gripper 4 rotates in the closing direction to transit the lead gripper 4 from the opened state to the closed state. When the lead gripper 4 is closed, the fingertips 421 abut on each other.

In the process where the lead gripper 4 closes, the electronic component 9 held by the component gripper 26 moves in the first directions 99 so as to separate from the electronic substrate, where the leads 92 fit into the guide grooves 422 of the lead gripper 4. Then, in the closed lead gripper 4, the leads 92 of the electronic component 9 are inserted into the guide holes formed by the guide grooves 422. Thus, even if the leads 92 are slightly bent or curved, the leads 92 are corrected to become straight by being pinched between the pair of fingers 40.

At last, the control device 6 moves the component gripper 26 to the attaching head 2 so that the leads 92 of the electronic component 9 are inserted into the through-holes of the electronic substrate. Here, in the attaching head 2, the component gripper 26 moves in the first directions 99 so as to approach the electronic substrate by the operation of the moving device 23. Note that, instead of the moving device 23, the component gripper 26 may be lowered by the operation of the attaching head moving mechanism 102.

The electronic component 9 sucked and held by the component gripper 26 moves toward the electronic substrate in association with the movement of the component gripper 26. Thus, the leads 92 of the electronic component 9 are inserted into the through-holes of the electronic substrate.

Moreover, in association with the movement of the component gripper 26, the operating member 25 moves from the first gap G1 to the second gap G2 so that the closed lead gripper 4 opens.

The opening operation of the lead gripper 4 is synchronized with the insertion of the leads 92 of the electronic component 9. When the tip-end parts of the leads 92 of the electronic component 9 are inserted into the through-holes of the electronic substrate, the leads 92 have still been gripped by the lead gripper 4. Therefore, the leads 92 of the electronic component 9 are inserted into the through-holes of the electronic substrate, while being guided by the guide holes of the lead gripper 4. Moreover, when the electronic component 9 lowers and a main body 91 thereof reaches above the electronic substrate, the lead gripper 4 is open and, thus, the movement of the main body of the electronic component 9 is not obstructed by the lead gripper 4.

As described above, the electronic-component inserting device 1 of this embodiment includes the component gripper 26 which holds the main body 91 of the electronic component 9, the operating member 25 provided to the component gripper 26, the lead gripper 4 which grips the leads 92 of the electronic component 9 held by the component gripper 26, and the moving device 23 which moves the component gripper 26 in the first directions 99 relatively to the lead gripper 4. The lead gripper 4 has the pair of fingers 40 which pinches the leads 92 of the electronic component 9 from both sides in the second directions 98 perpendicular to the first directions 99, the biasing member 47 which biases the fingertips 421 of the finger 40 to open, and the acted part 416 provided to the finger 40, which receives the acting force from the operating member 25 so that the fingertips 421 of the finger 40 are closed.

In the electronic-component inserting device 1, when the operating member 25 moves in the first directions 99 in association with the component gripper 26, the lead gripper 4 receives the acting force from the operating member 25 to close the fingertips 421 of the pair of fingers 40. That is, an actuator for exclusive use for opening and closing the lead gripper 4 is not provided, but the lead gripper 4 is mechanically opened and closed by the operating member 25 which integrally moves with the component gripper 26. Therefore, the timings of the movement of the component gripper 26 and the opening and closing of the lead gripper 4 are synchronized with each other, and their cooperation is promised. Moreover, since the actuator for exclusive use for opening and closing the lead gripper 4 is not provided, a controller for this actuator is unnecessary.

Moreover, in the electronic-component inserting device 1 according to this embodiment, the finger 40 includes the grip part 42 provided to the tip-end part, and the operating part 41 provided to the base-end part. The finger 40 is pivotably supported between the operating part 41 and the grip part 42 so that the grip parts 42 oppose to each other in the second directions 98, and the operating parts 41 oppose to each other in the second directions 98. In this operating part 41, the acted part 416 on which the operating member 25 located between the operating parts 41 acts, the escape part 412 which avoids the interference with the operating member 25 so that the operating member 25 located between the operating parts 41 does not act on the escape part 412, are formed adjacent to each other in the first directions 99.

Thus, when the operating member 25 reciprocates in the first directions 99 in association with the component gripper 26, the pair of fingers 40 of the lead gripper 4 can be opened and closed.

Further, in the electronic-component inserting device 1 according to this embodiment, the first directions 99 are parallel to the opening axes of the through-holes of the electronic substrate, and the escape part 412 is provided at the electronic substrate side with respect to the acted part 416.

Thus, in the process where the leads 92 of the electronic component 9 held by the component gripper 26 are inserted into the through-holes of the electronic substrate (this is an operation to move the component gripper 26 toward the electronic substrate in the first direction 99), the lead gripper 4 releases the gripped leads 92. Therefore, the lead gripper 4 can certainly guide the leads 92 of the electronic component 9 which are about to be inserted or are being inserted into the through-holes of the electronic substrate. Moreover, the insertion of the electronic component 9 and the release of the leads 92 by the lead gripper 4 are performed simultaneously, thereby shortening the work hours.

Moreover, in the electronic-component inserting device 1 according to this embodiment, the concaved part (the second gap G2) into which the operating member 25 is inserted is formed by the escape part 412 of the lead gripper 4, and the electronic-component inserting device 1 includes the moving mechanism (the guiding head moving mechanism 103) which moves the lead gripper 4 relatively to the component gripper 26 so that the operating member 25 is inserted into and removed from the concaved part.

Thus, when the operating member 25 fits into the concaved part, the component gripper 26 is positioned with respect to the lead gripper 4. Therefore, although the component gripper 26 and the lead gripper 4 are constructed independently, a positional offset or error of the component gripper 26 with respect to the lead gripper 4 is prevented.

Moreover, in the electronic-component inserting device 1 according to this embodiment, the guide grooves 422 which are used as the guide holes of the leads 92 are formed in the fingertips 421 of the finger 40 when the fingertips 421 are abutted on each other. The guide hole has the portion which extends in the first directions 99 and is reduced in the diameter toward the electronic substrate.

Even the leads 92 are bent or curved, the leads 92 are inserted into the through-holes of the electronic substrate while being corrected by the guide holes when the leads 92 are guided through the guide holes (the guide groove 422).

Moreover, the electronic-component inserting device 1 according to the embodiment further includes the first moving mechanism (i.e., the attaching head moving mechanism 102) which moves the component gripper 26 relatively to the substrate, and the second moving mechanism (i.e., the guiding head moving mechanism 103) which moves the lead gripper 4 relatively to the component gripper 26. In this embodiment, the first moving mechanism is one arm 12 of the dual-arm robot 10, and the second moving mechanism is the other arm 13 of the dual-arm robot 10.

As described above, in the electronic-component inserting device 1, the timings of the movement of the component gripper 26 and the opening and closing of the lead gripper 4 is synchronized with each other, the component gripper 26 can be positioned to the lead gripper 4, and a breakdown of the cooperation of the component gripper 26 and the lead gripper 4 does not occur easily. Therefore, in the electronic-component inserting device 1 according to this embodiment, the electronic-component inserting device 1 utilizing the dual-arm robot 10, in which the component gripper 26 and the lead gripper 4 are distributed to the arms 12 and 13, respectively, is easily implemented.

When the moving mechanism 102 of the component gripper 26 and the moving mechanism 103 of the lead gripper 4 operate independently, for example, the positioning of the lead gripper 4 to the electronic substrate, and the holding and conveyance of the electronic component 9 by the component gripper 26 are performed simultaneously, thereby shortening the work hours.

Although the suitable embodiment of the present disclosure is described above, the structure of the electronic-component inserting device 1 may be changed as follows, for example.

In the above embodiment, the component gripper 26 is a so-called suction-type gripper which causes the suction nozzle 261 to generate the absorbing force by the negative pressure or vacuum to suck and hold the electronic component 9 by the absorbing force at the suction nozzle 261. Note that the component gripper 26 is not limited to this embodiment, it may be a grip-type gripper (mechanical gripper), for example.

Moreover, in the above embodiment, although the operating member 25 is a single pin-shaped member, the operating member 25 may be comprised of a plurality of members. For example, the operating members 25 which act on the respective pair of fingers 40 may be provided.

Moreover, in the above embodiment, although the attaching head moving mechanism 102 and the guiding head moving mechanism 103 are the horizontal articulated robot arms 12 and 13, respectively, the attaching head moving mechanism 102 and the guiding head moving mechanism 103 are not limited to this structure. For example, the attaching head moving mechanism 102 and the guiding head moving mechanism 103 may be vertical articulated robot arms.

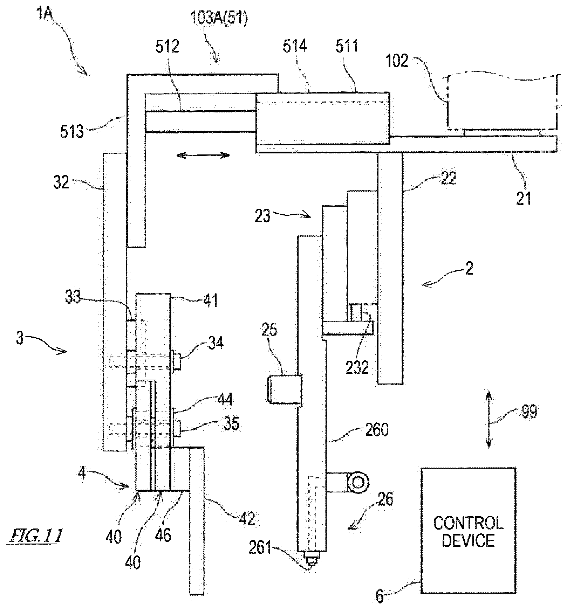

Moreover, the attaching head moving mechanism 102 and the guiding head moving mechanism 103 are not limited to the robot arms. For example, the attaching head moving mechanism 102 may be a robot arm, while the guiding head moving mechanism 103 may be a linear-motion mechanism attached to the robot arm. Fig. 11 illustrates an electronic-component inserting device 1A according to Modification 1 in which the attaching head moving mechanism 102 is a robot arm and the guiding head moving mechanism 103 is a linear-motion mechanism 51. The linear-motion mechanism 51 includes a cylinder 511 fixed to the interface plate 21, a rod 512 which extends and contracts the cylinder 511 horizontally, and a slider 513 attached to the rod 512. A horizontal rail 514 which guides the slider 513 is formed in a casing of the cylinder 511. A base 32 of the guiding head 3 is fixed to the slider 513. In the structure described above, when the rod 512 extends and contracts by operation of the cylinder 511, the lead gripper 4 moves relatively to the component gripper 26 so as to approach and separate from the component gripper 26.

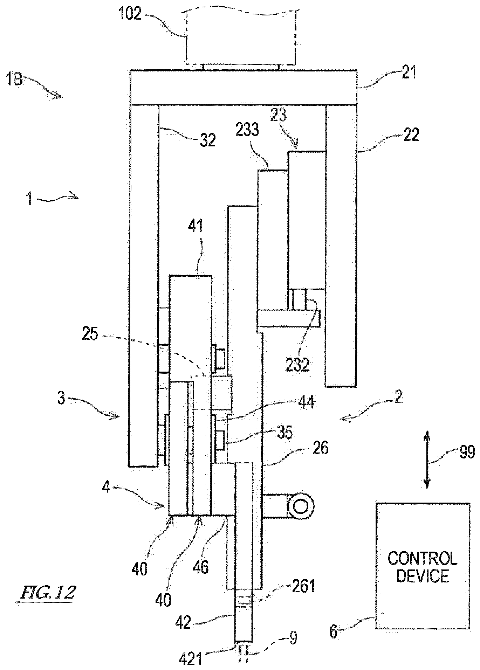

Moreover, in the above embodiment, although the attaching head 2 and the guiding head 3 are movable independently, the guiding head 3 may be combined with the attaching head 2. Fig. 12 illustrates an electronic-component inserting device 1B according to Modification 2 in which the guiding head 3 is combined with the attaching head 2. In this electronic-component inserting device 1B, the base 32 of the guiding head 3 is fixed to the interface plate 21 fixed to the base 22 of the attaching head 2. The operating member 25 in the stationary state is fitted into the second gap G2 of the lead gripper 4.

From the above description, it is apparent for a person skilled in the art that many improvements and other embodiments of the present disclosure may be possible. Therefore, the above description is to be interpreted only as illustration, and it is provided in order to teach a person skilled in the art the best mode to implement the present disclosure. Details of the structures and/or the functions may substantially be changed without departing from the spirit of the present disclosure.

### DESCRIPTION OF REFERENCE CHARACTERS

- 1:: Electronic-component Inserting Device
- 2:: Attaching Head
- 3:: Guiding Head
- 4:: Lead Gripper
- 6:: Control Device
- 9:: Electronic Component
- 91:: Main Body
- 92:: Lead
- 10:: Dual-arm Robot
- 11:: Pedestal
- 12, 13:: Robot Arm
- 21, 31:: Interface Plate
- 22, 31:: Base
- 23:: Moving Device
- 25:: Operating Member
- 26:: Component Gripper
- 260:: Arm
- 261:: Suction Nozzle
- 33:: Rotation Regulating Block
- 34:: Rotation Regulating Pin
- 35:: Pivot
- 40:: Finger
- 41:: Operating Part
- 411:: Rotation Regulating Hole
- 412:: Escape Part
- 415:: Contact Part (Acted Part)
- 416:: Acted Part
- 42:: Grip Part
- 421:: Fingertip
- 422:: Guide Groove
- 43:: Support Part
- 44:: Bearing Unit
- 45:: Fastener
- 46:: Spacer
- 47:: Biasing Member
- 51:: Linear-motion Mechanism
- 61:: Attaching Head Position Controller
- 62:: Guiding Head Position Controller
- 63:: Movement Controller
- 64:: Suction Controller
- 65:: Memory Device
- 102:: Attaching Head Moving Mechanism
- 103:: Guiding Head Moving Mechanism
- G1:: First Gap
- G2:: Second Gap
- O:: Pivot Center

## Claims

1. An electronic-component inserting device configured to insert an electronic component with leads into through-holes of a substrate, comprising:
a component gripper configured to hold a main body of the electronic component;
an operating member provided to the component gripper;
a lead gripper configured to grip the leads of the electronic component held by the component gripper; and
a moving device configured to move the component gripper in a first direction relatively to the lead gripper,
wherein the lead gripper has a pair of fingers configured to pinch the leads from both sides in second directions perpendicular to the first direction, and a biasing member configured to bias the pair of fingers so that fingertips of the fingers are opened, and
wherein the fingers are provided with acted parts on which an acting force from the operating member acts so that the fingertips of the fingers are closed.

2. The electronic-component inserting device of claim 1, wherein the finger has a grip part provided to a tip-end part thereof, and an operating part provided to a base-end part thereof, and the finger is pivotably supported between the operating part and the grip part so that the grip parts oppose to each other in the second directions and the operating parts oppose to each other in the second directions, and
wherein an acted part on which the operating member located between the operating parts acts, and an escape part configured to avoid interference with the operating member so that the operating member located between the operating parts do not act on the escape part, are formed adjacent to each other in the operating part in the first direction.

3. The electronic-component inserting device of claim 2, wherein the first direction is parallel to opening axes of the through-holes of the substrate, and the escape part is provided at the substrate side with respect to the acted part.

4. The electronic-component inserting device of claim 2 or 3, wherein a concaved part into which the operating member is inserted is formed in the lead gripper by the escape part, and
wherein the electronic-component inserting device further comprises a moving mechanism configured to move the lead gripper relatively to the component gripper so that the operating member is inserted into and removed from the concaved part.

5. The electronic-component inserting device of claim 1, further comprising:
a first moving mechanism configured to move the component gripper relatively to the substrate; and
a second moving mechanism configured to move the lead gripper relatively to the component gripper.

6. The electronic-component inserting device of claim 5, wherein the first moving mechanism is one of robot arms of a dual-arm robot, and the second moving mechanism is the other robot arm of the dual-arm robot.

7. The electronic-component inserting device of any one of claims 1 to 6, wherein guide grooves used as guide holes of the leads are formed in the fingertips of the fingers when the fingertips are abutted on each other, and the guide hole extends in the first direction and has a portion reduced in a diameter toward the substrate.
